# EUROPEAN PATENT SPECIFICATION

(11) **EP 0 592 768 B1**
(45) Date of publication and mention of the grant of the patent: **12.11.1997**
(21) Application number: 93109956.8
(22) Date of filing: 22.06.1993
(51) Int. Cl.: B29C 45/14

(54) **A process for co-molding a metal insert**
Verfahren zum in Kunststoff einzugiessender Metalleinlage
Procédé de surmoulage d'un insert métallique

(30) Priority: 28.07.1992 IT TO920648
(43) Date of publication of application: 20.04.1994
(73) Proprietor: ITW Fastex Italia S.p.A., I-10156 Torino (IT)
(72) Inventor: Cibin, Silvano, I-10040 Leini (IT)
(74) Representative: Jorio, Paolo, Dr. Ing.

(56) References cited:
- EP-A- 0 472 199
- US-A- 4 965 933
- US-A- 5 038 468
- US-A- 5 203 060
- PATENT ABSTRACTS OF JAPAN vol. 14, no. 19 (M-919)(3962) 16 January 1990 & JP-A-01 262 115 (SEIKO EPSON CORP) 19 October 1989

## Description

The present invention relates to a process for co-molding an insert forming a plurality of electrical circuits in a member of synthetic plastics material. The insert may be metallic.

The present invention also relates to equipment for carrying out the above co-molding process.

The preambles of claims 1 and 3 are based on US-A-4 965 933.

A process is known from Italian Patent No. TO91A000275 of 12.4.1991 for co-molding electrical circuits with members of plastics material, in which the operation of separating the electrical circuits, formed as a single metal insert, is carried out by cutting the metal insert inside the injection mold.

A blank holder associated with a cutting die and a punch cut the metal insert and also cooperate to hold it in a predetermined position during the injection of the fluid plastics material so as to avoid any movement of the insert.

However, the above process is not without disadvantages: the use of the blank holder, the punch and the cutting die to hold the insert in position during the injection phase means that the cut regions are not encapsulated in the synthetic plastics material, with the result that the cut edge portions of the metal insert are left exposed; this means that, if the co-molded electrical circuit is used, for example, in a situation with a high degree of humidity or in a very dusty situation, the cut metal parts could accidentally be short-circuited by water droplets or dust.

The process of US-A-4 965 933 does not provide cut regions that are fully encapsulated.

The object of the present invention is to provide a process and equipment for manufacturing an insert forming a plurality of electrical circuits in a member of synthetic plastics material which overcomes the disadvantages described above.

On this basis, the present invention according to claim 1 provides a process for co-molding an insert forming a plurality of electrical circuits in a synthetic plastics member.

The invention according to claim 3 also provides equipment for the co-molding of a metal insert forming a plurality of electrical circuits in a synthetic plastics member.

In order to provide a better understanding of the invention, there follows a description, given purely by way of a non-limitative example, with reference to the appended drawings, in which:
Figure 1 is a partial, schematic view of equipment for carrying out the process of the invention at a first step in production;
Figure 2 shows the equipment of Figure 1 on an enlarged scale and at a subsequent step in the process;
Figure 3 is a section taken on the line III-III of the equipment of Figure 2;
Figure 4 shows an enlarged detail of Figure 2;
Figure 5 shows the equipment of Figure 2 in a later step in the process of the invention;
Figure 6 shows an enlarged detail of the equipment of Figure 5 at a subsequent step; and
Figure 7 schematically illustrates a metal insert used in the process according to the invention.

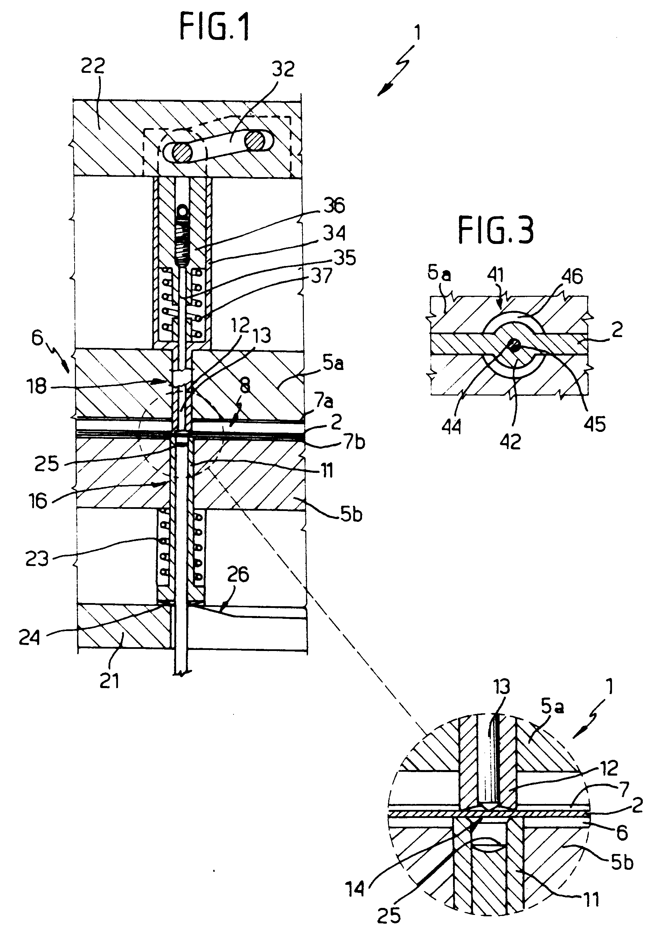

With reference to Figures 1 to 7, equipment is indicated 1 for co-molding an insert 2 in a member 3 of synthetic plastics material; the insert 2 forms a plurality (for example two) of electrical circuits 4 (Figure 7).

The equipment 1 comprises essentially a pair of half-molds 5a and 5b, constituting an injection mold 6, provided with respective cavities 7a and 7b for molding the member 3 while the metal insert 2 is clamped in a predetermined position 8 inside the cavities 7 by at least one tubular die 11 and a blank holder 12.

The equipment 1 is also provided with a punch 13 slidable within the blank holder 12 and cooperating with the die 11 to cut the insert 2 at a junction region 14 between the electrical circuits 4 so as to obtain respective cut metal parts 15, thereby separating the circuits 4 both mechanically and electrically.

According to the invention, the blank holder 12, the die 11 and the punch 13 are axially slidable inside the half-molds 5 in respective fluid-tight through-seats 16 and 18 formed in the half-molds and opening into the respective cavities 7.

The equipment 1 is in fact provided with two carriages 21 and 22 which effect the controlled axial displacement of the blank holder 12, of the die 11 and of the punch 13.

The die 11, which is provided with a preloaded spring 23, cooperates with the first carriage 21 which is movable perpendicular to the direction of movement of the die 11 itself; at one end 24, opposite a second end 25 facing the insert 2, the die 11 is rounded and cooperates slidingly with an inclined plane 26 formed on the carriage 21; in this way, the translational movement of the carriage 21 causes an associated movement of the die 11 in the seat 16 due to the action of the spring 23.

The punch 13 and the blank holder 12 are supported by a support frame 31 of the respective half-mold 5a and are slidably mounted, the former within the latter, and fixed by a cam 32 to the second carriage 22 which is movable perpendicular to the direction of movement of the punch 13 and of the blank holder 12 and effects the controlled movement of these latter; the blank holder 12 includes an outer sleeve 34 in which a rod 35 which defines the punch 13 is slidable; a carrier sleeve 36 is connected to the cam 32 while a spring 37 is arranged between the outer sleeve 34 and the carrier sleeve 36 for providing resilient biasing for the blank holder 12.

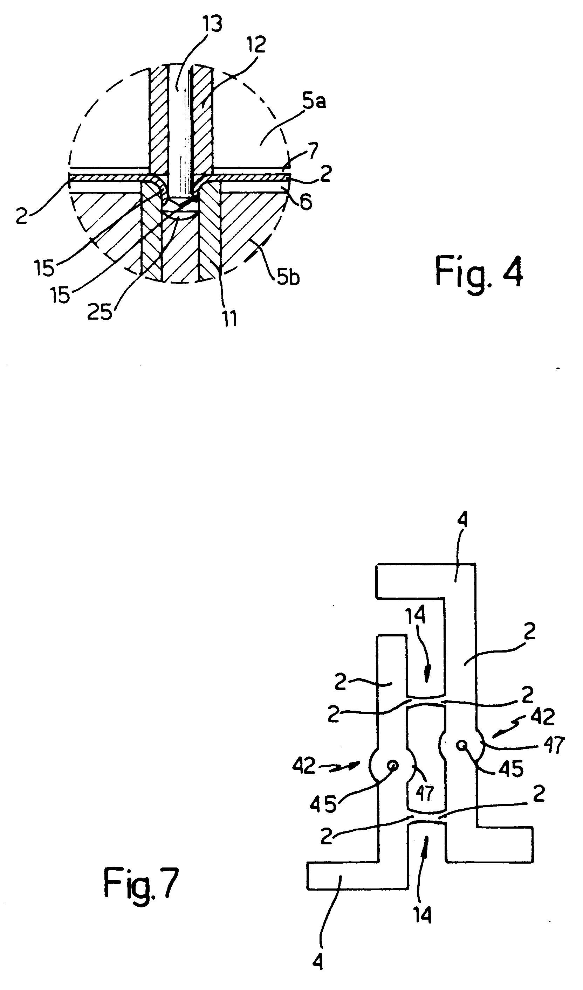

In order to hold the metal insert in the predetermined position 8, both before and during the injection of a fluid synthetic plastics material 33 into the cavities 7 when the blank holder 12, the die 11 and the punch 13 have been withdrawn by the carriages 21 and 22, the equipment 1 also includes a series of plungers 41 which act at restraining regions 42 of the metal insert 2 (Figure 3) which differ from the junction regions 14.

The plungers 41 are provided with respective springs 43, appropriately calibrated to transmit a predetermined force, and with tips 44 for coupling with respective centering holes 45 formed in the restraining regions 42 of the metal insert 2 (Figure 7).

With reference in particular to Figures 3 and 7, the plungers 41 have a active surfaces 46 which are substantially larger than the corresponding contact surfaces 47 of the corresponding restraining regions 42 so that they project beyond the edges of these latter within the cavities 7 and, during the injection step and after the cavities 7 have been filled with fluid plastics material 33, are acted upon by the hydrostatic pressure which is such as to overcome the action of the springs 43 and thus enables the cavities 7 to be completely filled with the plastics material 33, even around the restraining regions 42.

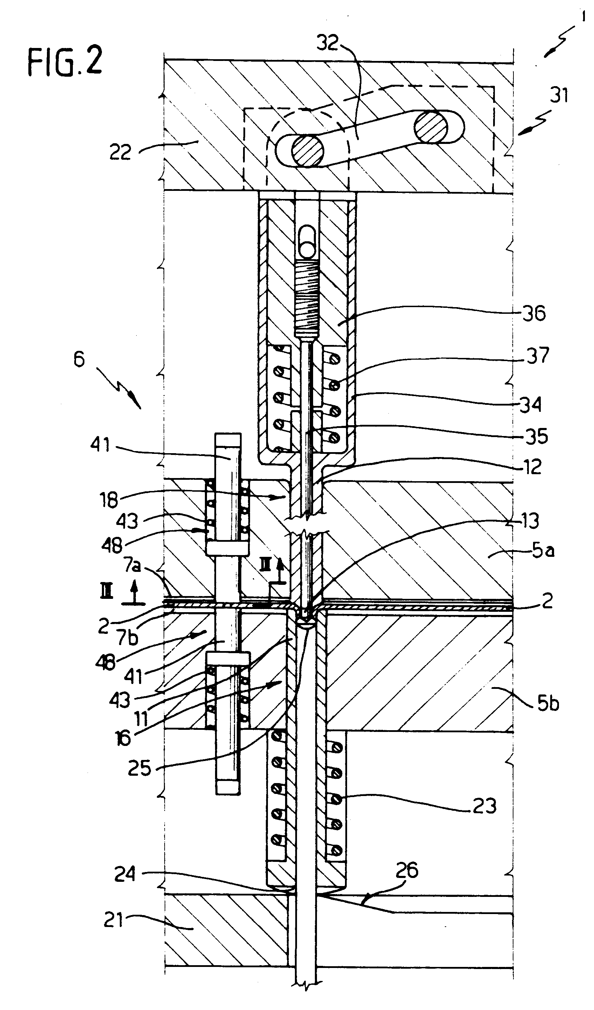

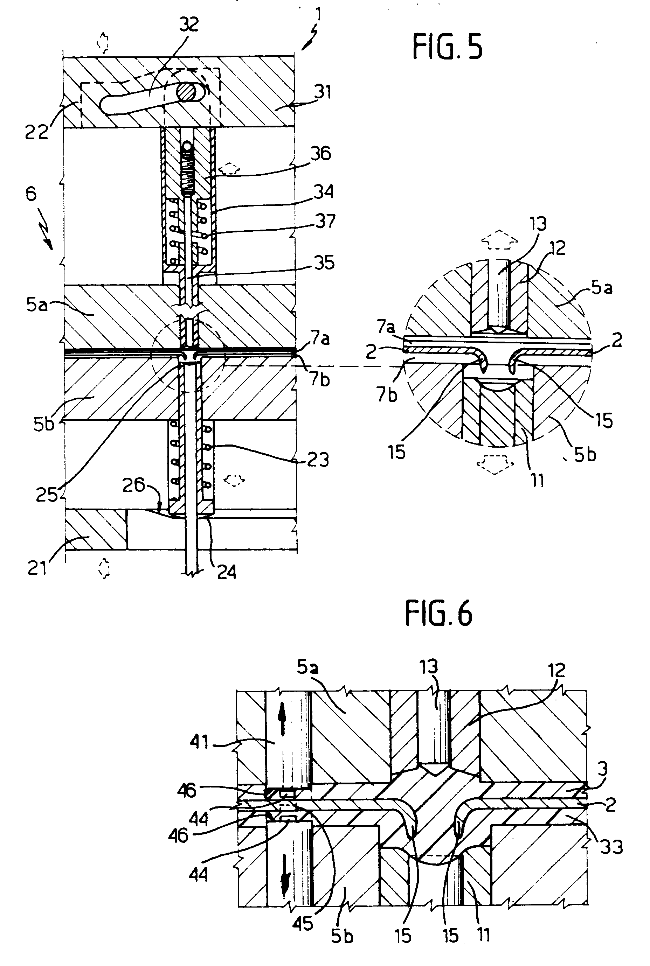

The process for the co-molding of the insert 2 in a member 3 of synthetic plastics material consists essentially of the following steps: a first step (Figure 1) in which the insert 2 is arranged between the two half-molds 5 and, once the mold 6 is closed, the metal insert 2 is clamped in the predetermined position 8 both by the mutual cooperation of the blank holder 12 and the die 11 and by the plungers 41 which couple with the corresponding restraining regions 42; a second step (Figure 2) in which the insert 2 is cut by the punch 13 with the formation of the cut metal parts 15; and a third step (Figure 5) in which the punch 13, together with the blank holder 12 and the die 11, is moved away from the metal insert 2 which at this point is held in the predetermined position 8 by the plungers 41 alone.

Next comes the injection step (Figure 6) during which a fluid synthetic plastics material 33 is injected into the cavities 7, totally encapsulating the metal insert 2; once the cavities 7 have been filled, the hydrostatic pressure of the fluid plastics material 33 forces the plungers back into respective chambers 48 formed in the half-molds 5 and thus allows the cavities 7 to be completely filled with the fluid plastics material 33.

At the end of the injection step and after the member 3 has cooled, the latter is pushed out of the mold 6 by an ejector pin which is slidable in the die 11.

The advantages of the present invention will be apparent from the above description; the co-molding process described enables the production, in a single operation and with the use of a single piece of equipment, of a synthetic plastics member which completely encapsulates an insert forming a plurality of circuits, even in those regions at the junctions between its electrical circuits (Figure 5) in which the insert is cut; this avoids the disadvantages of circuits in which the regions in which the inserts are cut are not suitably electrically insulated.

## Claims

1. A process for co-molding a insert (2) forming a plurality of electrical circuits (4) in a synthetic plastics member (3), comprising the steps of:
- arranging the insert (2) inside respective cavities (7) of a mold (6) for the production of said synthetic plastics member (3);
- cutting respective junction regions (14) between said electrical circuits (4) of said insert (2) to obtain respective cut metal parts (15), so as to achieve the mechanical and electrical separation of the circuits (4) themselves;
- holding said electrical circuits (4) in said cavities (7) at regions (42) thereof other than said junction regions (14);
- withdrawn respective dies (11) and punches (13) for executing the step of cutting said junction regions (14) from said cavities (7) into respective seats (16, 18) in the mold (6); and
- injecting a fluid plastics material (33) into said mold (6) to mold the plastics member (3) and embed said insert (2) therein;
**characterized in that:**
- said holding step is carried out both before and during said injection step, at respective restraining regions (42) of each of said electrical circuits (4) designed to be embedded too in said plastic member (3);
- said withdrawing step is carried out with said mold closed, keeping said dies (11) and punches (13) into said seats (16, 18) so as to delimit with said dies and punches (11, 13), and together with said seats (16, 18), respective portions of said cavities (7) in which said plastics member will be formed with respective solid portions which will completely encapsulate the metal parts (15) at the junction regions (14) and maintain them electrically separated; and
- said restraining regions (42) are held by means of pressure elements (41) movable against the action of biasing means (43) inside respective recesses (48) in the mold (6) facing said cavities (7), each pressure element (41) having an active surface (46) with an area substantially larger than that of a corresponding contact surface (47) of the restraining regions (42), said active surfaces projecting beyond the restraining regions (42) into said cavities (7) to receive, during the injection step and after the filling of said cavities (7) with said fluid plastics material (33), a hydrostatic thrust able to overcome the action of said biasing means (43).

2. A process as claimed in Claim 1, characterized in that it comprises a first step during which said insert (2) is arranged between said two half-molds (5) and then, with the mold (6) closed, said insert (2) is clamped in a predetermined position (8) due to the cooperation of blank holder means (12) and die means (11); a second step in which said insert (2) is cut by means of said punch (13) with the consequent production of two cut metal parts (15); a third step in which the punch (13), the blank holder means (12) and the die means (11) are withdrawn while the insert (2) is restrained in said predetermined position (8) by the action of pressure means (41) on said respective restraining regions (42), the pressure means being acted upon by respective biasing means (43); and an injection step in which the fluid plastics material (33) is injected and fills said cavities (7) of the mold (6) and completely encapsulates the insert (2) within it; the static pressure of said fluid (33), after said cavities (7) have been filled, causing the pressure means (41) to return into respective recesses (48) to allow the complete filling of said cavities (7) with said fluid plastics material (33); after the completion of the injection step and the cooling of the plastics material (33), the co-molded member (3) being removed by respective removal means.

3. Equipment (1) for the co-molding of a insert (2) forming a plurality of electrical circuits (4) in a synthetic plastics member (3), of the kind comprising a pair of half-molds (5) provided with respective cavities (7) for molding said member (3) from a plastics material, die means (11) and blank holder means (12) for clamping the insert (2) in said cavities (7) at respective junction regions (14) thereof between the electrical circuits (4), and punch means (13) for cutting said junction regions (14) to obtain cut metal parts (15) unconnected to each other due to the mechanical and electrical separation of said circuits (4);
characterized in that
(i)- said punch means (13), said die means (11) and said blank holder means (12) are mounted for axial sliding movement with substantially fluid-tight seals within respective through-seats (16,18) formed in said half-molds (5) and opening into said cavities (7);
(ii)- said punch means (13), die means (11) and blank holder means (12) are so shaped and arranged that, when they are in a retracted position within said seats (16,18), they are able to define, together with said seat themselves, respective portions of said cavities (7) designed to form respective solid portions of said plastic member (3) which will completely encapsulate said cut metal parts (15) at the junction regions (14) and maintain them electrically separated; and
(iii) said equipment (1) further includes:
- means (21, 22) for effecting the controlled displacement of said punch means (13), said die means (11) and said blank holder means (12); and
- restraining means (41) for holding the insert (2) at restraining regions (42) of each of said electrical circuits (4) designed to be embedded too in said plastic member (3) and other than said junction regions (14);
- said restraining means consisting of pressure elements (41) movable against the action of biasing means (43) inside respective recesses (48) in the mold (6) facing said cavities (7), each pressure element (41) having an active surface (41) with an area substantially larger than that of a corresponding contact surface (47) of the restraining regions (42), said active surfaces projecting beyond the restraining regions (42) into said cavities (7) to receive, during the injection step and alter the filling of said cavities (7) with said fluid plastics material (33), a hydrostatic thrust able to overcome the action of said biasing means (43).

4. Equipment as claimed in Claim 3, characterized in that said restraining means (41) are constituted by plungers (41) provided with resilient biasing means (43) calibrated to transmit a predetermined force and having respective tips (44) for coupling with centering holes (45).

5. Equipment as claimed in Claim 3 or Claim 4, characterized in that said die means (11) include a preloaded spring (23) and cooperate with a first carriage (21) movable perpendicular to the direction of movement of said die means (11); said die means (11) having a first end (24) opposite a second end (25) facing said insert (2), said first end having a rounded shape and cooperating with a respective inclined plane (26) formed on said first carriage (21); said punch means (13) and blank holder means (12) being supported by a respective support frame (31) of the respective half-mold (5a) and being slidably assembled the first within the second and connected by cam means (32) to a second carriage (22) movable perpendicular to the direction of movement of said punch means (13) and blank holder means (12).

6. Equipment (1) as claimed in Claim 5, characterized in that said blank holder means (12) comprise an outer sleeve (34) housing a rod (35) defining said punch means (13) for sliding therein, a carrier sleeve (36) connected to said cam means (32) and respective spring means (37) for said blank holder means (12) arranged between said outer sleeve (34) and said carrier sleeve (36).

## Patentansprüche

1. Verfahren zum Eingießen einer Einlage (2), die eine Vielzahl elektrischer Schaltkreise (4) bildet, in ein Bauteil (3) aus synthetischem Kunststoff, das die folgenden Schritte umfaßt:
- Anordnen der Einlage (2) innerhalb der entsprechenden Hohlräume (7) einer Gußform (6) zur Herstellung des Bauteils (3) aus synthetischem Kunststoff;
- Schneiden von jeweiligen Verbindungsbereichen (14) zwischen den elektrischen Schaltkreisen (4) der Einlage (2), um entsprechende geschnittene Metallteile (15) zu erhalten, um die mechanische und elektrische Trennung der Schaltkreise (4) selbst zu erreichen;
- Festhalten der elektrischen Schaltkreise (4) in den Hohlräumen (7) an anderen Bereichen (42) als den Verbindungsbereichen (14);
- Zurückziehen entsprechender Stempel (11) und Stanzwerkzeuge (13) zur Ausführung des Schrittes des Schneidens der Verbindungsbereiche (14) aus den Hohlräumen (7) heraus in die entsprechenden Aufnahmen (16, 18) in der Gußform (6) hinein; und
- Einspritzen eines flüssigen Kunststoffmaterials (33) in die Gußform (6), um das Kunststoffbauteil (3) zu gießen und die Einlage (2) darin einzubetten;
dadurch gekennzeichnet, daß:
- der Festhalteschritt sowohl vor als auch während des Einspritzschritts an den entsprechenden Einspannbereichen (42) jedes elektrischen Schaltkreises (4) durchgeführt wird, die auch in das Kunststoffbauteil (3) eingebettet werden sollen;
- der Zurückziehschritt mit geschlossener Gußform durchgeführt wird, wobei die Stempel (11) und Stanzwerkzeuge (13) in den Aufnahmen (16, 18) bleiben, um so mit den Stempeln (11) und Stanzwerkzeugen (13) und gemeinsam mit den Aufnahmen (16, 18) die jeweiligen Abschnitte der Hohlräume (7) abzugrenzen, in denen das Kunststoffbauteil mit den jeweiligen festen Bereichen gebildet wird, die die Metallteile (15) an den Verbindungsbereichen (14) vollständig einhüllen und sie elektrisch getrennt halten; und
- die Einspannbereiche (42) mit Hilfe von Druckelementen (41) festgehalten werden, die gegen die Wirkung von Spannmitteln (43) innerhalb entsprechender Ausnehmungen (48) in der Gußform (6) gegenüber den Hohlräumen (7) bewegbar sind, wobei jedes Druckelement (41) eine aktive Oberfläche (46) mit einer Fläche aufweist, die wesentlich größer ist als die einer entsprechenden Berührungsfläche (47) der Einspannbereiche (42), wobei die aktiven Oberflächen über die Einspannbereiche (42) hinaus in die Hohlräume (7) hineinragen, um während des Einspritzschritts und nach der Füllung der Hohlräume (7) mit dem Kunststoffmaterial (33) einen hydrostatischen Druck aufzunehmen, der die Wirkung der Lagermittel (43) überwinden kann.

2. Verfahren nach Anspruch 1, dadurch gekennzeichnet, daß es einen ersten Schritt umfaßt, bei dem die Einlage (2) zwischen zwei Gußformhälften (5) angeordnet wird und dann bei geschlossener Gußform (6) aufgrund des Zusammenwirkens des Niederhaltemittels (12) mit dem Stempel (11) die Einlage (2) in einer vorbestimmten Stellung (8) festgeklemmt wird; einen zweiten Schritt, bei dem die Einlage (2) mit Hilfe des Stanzwerkzeugs (13) unter daraus resultierender Schaffung zweier geschnittener Metallteile (15) geschnitten wird; einen dritten Schritt, in dem das Stanzwerkzeug (13), der Niederhalter (12) und der Stempel (11) zurückgezogen werden, während die Einlage (2) in der vorbestimmten Stellung (8) durch die Einwirkung von Druckmitteln (41) auf die entsprechenden Einspannbereiche (42) festgehalten wird, wobei die Druckmittel durch entsprechende Spannmittel (43) betätigt werden; und einen Einspritzschritt, bei dem das flüssige Kunststoffmaterial (33) eingespritzt wird und die Hohlräume (7) der Gußform (6) füllt und die Einlage (2) vollständig in sich einhüllt; wobei nachdem die Hohlräume (7) gefüllt worden sind, der statische Druck der Flüssigkeit (33) die Spannmittel (41) dazu bringt, in die jeweiligen Ausnehmungen (48) zurückzukehren, um die völlige Füllung der Hohlräume (7) mit dem flüssigen Kunststoffmaterial (33) zu ermöglichen; wobei nach der Beendigung des Einspritzschritts und der Abkühlung des Kunststoffmaterials (33) das gegossene Bauteil (3) durch entsprechende Lösemittel entnommen wird.

3. Vorrichtung (1) zum Eingießen einer Einlage (2), die eine Vielzahl elektrischer Schaltkreise (4) bildet, in ein Bauteil aus synthetischem Kunststoff (3), die von dem Typ ist, daß sie zwei Gußformhälften (5) aufweist, die mit entsprechenden Hohlräumen (7) zum Gießen des Bauteils (3) aus Kunststoffmaterial versehen sind, und Stempel (11) und Niederhalter (12) zum Festklemmen der Einlage (2) in den Kohlräumen (7) an deren entsprechenden Verbindungsbereichen (14) zwischen den elektrischen Schaltkreisen (4) aufweist, sowie Stanzwerkzeuge (13) zum Schneiden der Verbindungsbereiche (14), um geschnittene Metallteile (15) zu erhalten, die aufgrund der mechanischen und elektrischen Trennung der Schaltkreise (4) miteinander nicht verbunden sind;
dadurch gekennzeichnet, daß
(i)- das Stanzwerkzeug (13), der Stempel (11) und der Niederhalter (12) für eine Schiebebewegung in Achsrichtung mit im wesentlichen flüssigkeitsdichten Abdichtungen in entsprechenden durchgehenden Aufnahmen (16, 18) gelagert sind, die in den Gußformhälften (5) angeordnet sind und sich zu den jeweiligen Hohlräumen (7) hin öffnen;
(ii)- das Stanzwerkzeug (13), der Stempel (11) und der Niederhalter, (12) so ausgelegt und angeordnet sind, daß sie, wenn sie sich in zurückgezogener Stellung in den Aufnahmen (16, 18) befinden, zusammen mit der Aufnahme selbst die entsprechenden Bereiche der Hohlräume (7) abgrenzen können, die die entsprechenden festen Bereiche des Kunststoffbauteils (3) bilden, die die geschnittenen Metallteile (15) an den Verbindungsbereichen (14) vollständig einschließen und sie elektrisch getrennt halten; und
(iii)- wobei die Vorrichtung (1) ferner umfaßt:
- Mittel (21, 22), um die gesteuerte Verlagerung des Stanzwerkzeugs (13), des Stempels (11) und des Niederhalters (12) zu bewerkstelligen; und
- Einspannmittel (41), um die Einlage (2) an den Einspannbereichen (42) jedes elektrischen Schaltkreises (4) festzuhalten, die auch in das Kunststoffbauteil (3) eingehüllt werden sollen und die sich von den Verbindungsbereichen (14) unterscheiden;
- wobei das Einspannmittel aus Druckelementen (41) besteht, die gegen die Wirkung der Spannmittel (43) innerhalb der entsprechenden Ausnehmungen (48) in der Gußform (6), die den Hohlräumen (7) zugewendet sind, bewegbar sind, wobei jedes Druckelement (41) eine aktive Oberfläche (41) mit einer Fläche aufweist, die wesentlich größer ist als die einer entsprechenden Berührungsfläche (47) der Einspannbereiche (42), wobei die aktiven Oberflächen über die Einspannbereiche (42) hinaus in die Hohlräume (7) hineinragen, um während des Einspritzschritts und nach der Füllung der Hohlräume (7) mit dem Kunststoffmaterial (33) einen hydrostatischen Druck aufzunehmen, der die Wirkung der Spannmittel (43) überwinden kann.

4. Vorrichtung nach Anspruch 3, dadurch gekennzeichnet, daß die Einspannmittel (41) durch Bolzen (41) gebildet sind, die mit elastischen Spannmitteln (43) versehen sind, die zur Übertragung einer vorbestimmten Kraft kalibriert sind und die entsprechende Spitzen (44) zum Ankoppeln an Zentrierlöcher (45) aufweisen.

5. Vorrichtung nach Anspruch 3 oder Anspruch 4, dadurch gekennzeichnet, daß die Stempel (11) eine vorgespannte Feder (23) umfassen und mit einem ersten Schlitten (21) zusammenwirken, der senkrecht zu der Bewegungsrichtung der Stempel (11) bewegbar ist; wobei die Stempel (11) ein erstes Ende (24) aufweisen, das einem zweiten Ende (25), das der Einlage (2) zugewendet ist, gegenüberliegt, wobei das erste Ende eine abgerundete Form aufweist und mit einer entsprechenden geneigten Ebene (26) zusammenwirkt, die auf dem ersten Schlitten (21) angeordnet ist; wobei das Stanzwerkzeug (13) und der Niederhalter (12) von einem entsprechenden Trägerrahmen (31) der entsprechenden Gußformhälfte (5a) getragen werden, und wobei das erste im zweiten verschiebbar angeordnet ist und durch ein Nockenmittel (32) mit einem zweiten Schlitten (22) verbunden ist, der senkrecht zur Bewegungsrichtung des Stanzwerkzeugs (13) und des Niederhalters (12) bewegbar ist.

6. Vorrichtung (1) nach Anspruch 5, dadurch gekennzeichnet, daß die Niederhalter (12) eine Außenmanschette (34) umfassen, in der ein Kolben (35) untergebracht ist, der das Stanzwerkzeug (13) definiert, und darin verschiebbar ist, und eine Trägermanschette (36), die mit dem Nockenmittel (32) verbunden ist sowie entsprechende Federmittel (37) für den Niederhalter (12) die zwischen der Außenmanschette (34) und der Trägermanschette (36) angeordnet sind.

## Revendications

1. Procédé de surmoulage d'un insert (2) formant plusieurs circuits électriques (4) dans un élément en matière plastique synthétique (3), comprenant les étapes :
- de disposition de l'insert (2) à l'intérieur de cavités (7) respectives d'un moule (6) pour la production dudit élément en matière plastique synthétique (3) ;
- de découpage des régions de jonction (14) respectives, entre lesdits circuits électriques (4) dudit insert (2) pour obtenir des parties métalliques découpées (15) respectives, de façon à obtenir la séparation mécanique et électrique des circuits (4) eux-mêmes ;
- de maintien desdits circuits électriques (4) dans lesdites cavités (7) au niveau de leurs régions (42) autres que lesdites régions de jonction (14) ;
- de retrait des matrices (11) et des poinçons (13) respectifs pour exécuter l'étape de découpage desdites régions de jonction (14) desdites cavités (7) dans des logements respectifs (16, 18) du moule (6) ; et
- d'injection d'une matière plastique sous forme fluide (33) dans ledit moule (6) pour mouler l'élément en matière plastique (3) et y intégrer ledit insert (2) ;
caractérisé :
- en ce que ladite étape de maintien est effectuée, à la fois, avant et pendant ladite étape d'injection, au niveau de régions de maintien (42) respectives de chacun desdits circuits électriques (4) conçues pour être aussi intégrées dans ledit élément en matière plastique (3) ;
- en ce que ladite étape de retrait est effectuée, ledit moule étant fermé, en conservant lesdites matrices (11) et lesdits poinçons (13) dans lesdits logements (16, 18) de façon à délimiter, à l'aide desdits matrices et poinçons (11, 13), et conjointement avec lesdits logements (16, 18), des parties respectives desdites cavités (7) dans lesquelles ledit élément en matière plastique sera formé avec des parties solides respectives qui encapsuleront complètement les parties métalliques (15) au niveau des régions de jonction (14) et les maintiendront séparées du point de vue électrique ; et
- en ce que lesdites régions de maintien (42) sont maintenues au moyen d'éléments de pression (41) mobiles en opposition à l'action de moyens de rappel (43) à l'intérieur d'évidements (48) respectifs situés dans le moule (6), faisant face auxdites cavités (7), chaque élément de pression (41) comportant une surface active (46) avec une superficie sensiblement plus grande que celle d'une surface de contact (47) correspondante des régions de maintien (42), lesdites surfaces actives faisant saillie au-delà des régions de maintien (42) dans lesdites cavités (7) pour recevoir, au cours de l'étape d'injection et après le remplissage desdites cavités (7) avec ladite matière plastique sous forme fluide (33), une poussée hydrostatique pouvant contrer l'action desdits moyens de rappel (43).

2. Procédé selon la revendication 1, caractérisé en ce qu'il comprend une première étape au cours de laquelle ledit insert (2) est disposé entre deux demi-moules (5) et, ensuite, le moule (6) étant fermé, ledit insert (2) est bloqué dans une position prédéterminée (8) du fait de la coopération d'un moyen formant presse-tôle (12) et d'un moyen formant matrice (11) ; une deuxième étape à laquelle ledit insert (2) est découpé au moyen dudit poinçon (13), avec pour conséquence la production de deux parties métalliques découpées (15) ; une troisième étape à laquelle le poinçon (13), le moyen formant presse-tôle (12) et le moyen formant matrice (11) se retirent alors que l'insert (2) est maintenu dans ladite position prédéterminée (8) par l'action des moyens de pression (41) sur lesdites régions de maintien (42) respectives, les moyens de pression étant sollicités par les moyens de rappel respectifs (43) ; et une étape d'injection à laquelle la matière plastique sous forme fluide (33) est injectée et remplit lesdites cavités (7) du moule (6) et y encapsule complètement l'insert (2) ; la pression statique dudit fluide (33), après remplissage desdites cavités (7), provoquant le retour des moyens de pression (41) dans les évidements (48) respectifs pour permettre le remplissage complet desdites cavités (7) avec ladite matière plastique sous forme fluide (33) ; après l'accomplissement de l'étape d'injection et le refroidissement de la matière plastique (33), l'élément surmoulé (3) étant retiré par un moyen de retrait respectif.

3. Outillage (1) pour le surmoulage d'un insert (2) formant plusieurs circuits électriques (4) dans un élément en matière plastique synthétique (3), du type comprenant une paire de demi-moules (5) pourvus de cavités (7) respectives pour mouler ledit élément (3) d'une matière plastique, un moyen formant matrice (11), et un moyen formant presse-tôle (12) pour bloquer l'insert (2) dans lesdites cavités (7) au niveau de leurs régions de jonction (14) respectives entre les circuits électriques (4), et un moyen formant poinçon (13) destiné à découper lesdites régions de jonction (14) pour obtenir des parties métalliques découpées (15) séparées les unes des autres en raison de la séparation mécanique et électrique desdits circuits (4) ;
caractérise :
(i) en ce que ledit moyen formant poinçon (13), ledit moyen formant matrice (11) et ledit moyen formant pressetôle (12) sont montés pour se déplacer en coulissant axialement avec des joints sensiblement étanches dans des logements traversants (16, 18) respectifs formés dans lesdits demi-moules (5) et débouchant dans lesdites cavités (7) ;
(ii) en ce que ledit moyen formant poinçon (13), ledit moyen formant matrice (11) et ledit moyen formant pressetôle (12) sont formés et agencés pour, lorsqu'ils sont dans une position de retrait dans lesdits logements (16, 18), être capables de définir, conjointement avec lesdits logements eux-mêmes, des parties respectives desdites cavités (7) conçues pour former des parties solides respectives dudit élément en matière plastique (3) qui encapsuleront entièrement lesdites parties métalliques découpées (15) au niveau des régions de jonction (14) et les maintiendront séparées du point de vue électrique ; et
(iii) en ce que ledit outillage (1) comprend en outre :
- des moyens (21, 22) destinés à effectuer le déplacement commandé dudit moyen formant poinçon (13), dudit moyen formant matrice (11) et dudit moyen formant presse-tôle (12) ; et
- un moyen de maintien (41) destiné à maintenir l'insert (2) au niveau de régions de maintien (42) de chacun desdits circuits électriques (4) conçues pour être aussi intégrées dans ledit élément en matière plastique (3), et autres que lesdites régions de maintien (14) ;
- ledit moyen de maintien étant constitué d'éléments de pression (41) mobiles en opposition à des moyens de rappel (43) situés dans des évidements (48) respectifs du moule (6), faisant face auxdites cavités (7), chaque élément de pression (41) comportant une surface active (41) avec une superficie sensiblement plus grande que celle d'une surface de contact (47) correspondante des régions de maintien (42), lesdites surfaces actives faisant saillie au-delà des régions de maintien (42) dans lesdites cavités (7) pour recevoir, pendant l'étape d'injection et après le remplissage desdites cavités (7) avec ladite matière plastique sous forme fluide (33), une poussée hydrostatique apte à contrer l'action desdits moyens de rappel (43).

4. Outillage selon la revendication 3, caractérisé en ce que lesdits moyens de maintien (41) sont constitués de pistons (41) munis de moyens de rappel élastiques (43) calibrés pour transmettre une force prédéterminée et comportant des embouts (44) respectifs pour couplage avec des trous de centrage (45).

5. Outillage selon la revendication 3 ou 4, caractérisé en ce que lesdits moyens formant matrice (11) comprennent un ressort précontraint (23) et coopèrent avec un premier chariot (21) mobile perpendiculairement à la direction de déplacement desdits moyens formant matrice (11) ; lesdits moyens formant matrice (11) comportant une première extrémité (24) opposée à une seconde extrémité (25) faisant face audit insert (2), ladite première extrémité ayant une forme arrondie et coopérant avec un plan incliné (26) respectif formé sur ledit premier chariot (21) ; lesdits moyens formant poinçon (13) et le moyen formant presse-tôle (12) étant supportés par un châssis de support (31) respectif du demi-moule (5a) respectif et étant assemblés de manière coulissante, le premier à l'intérieur du second et reliés par un moyen de came (32) à un second chariot (22) mobile perpendiculairement à la direction de déplacement desdits moyens formant poinçon (13) et du moyen formant presse-tôle (12).

6. Outillage (1) selon la revendication 5, caractérisé en ce que ledit moyen formant presse-tôle (12) comprend une boîte de glissement externe (34) logeant une barre (35) définissant lesdits moyens formant poinçon (13) pour y coulisser, un manchon support (36) relié audit moyen de came (32) et des moyens formant ressort respectifs (37) pour ledit moyen formant presse-tôle (12) agencés entre ladite boîte de glissement externe (34) et ledit manchon support (36).
